# EUROPEAN PATENT APPLICATION

(11) **EP 4 362 614 A1**
(43) Date of publication of application: **01.05.2024**
(21) Application number: 22828287.7
(22) Date of filing: 15.06.2022
(51) Int. Cl.: H05K 3/46, H01L 23/12, H01L 23/14, H01L 23/15, H05K 3/00

(54) **CIRCUIT BOARD MANUFACTURING METHOD**

(30) Priority: 24.06.2021 JP 2021104981; 04.02.2022 JP 2022016385
(71) Applicant: Mitsui Mining & Smelting Co., Ltd., Shinagawa-ku Tokyo 141-8584 (JP)
(72) Inventor: KITABATAKE Yukiko, Ageo-shi, Saitama 362-0021 (JP); NAKAMURA Toshimi, Ageo-shi, Saitama 362-0021 (JP); MATSUURA Yoshinori, Ageo-shi, Saitama 362-0021 (JP)
(74) Representative: Potter Clarkson
(86) International application number: PCT/JP2022/023905
(87) International publication number: WO 2022/270370

(57) **Abstract**

Provided is a method for manufacturing a wiring substrate that can easily and reliably release a carrier. The method includes: providing a laminated sheet that includes a release layer and a metal layer in order on a carrier; forming a cut from a surface of the laminated sheet opposite to the carrier so that the cut passes through the inside of an outer edge portion of the laminated sheet and so that the cut penetrates the metal layer and the release layer, and dividing the metal layer and the release layer into a central portion and a peripheral portion with the cut as a boundary; and inserting a thin piece from the cut toward the central portion side of the metal layer or the release layer to form a gap between the metal layer and the carrier in which an insertion angle of the thin piece is greater than 0°.

## Description

### TECHNICAL FIELD

The present invention relates to a method for manufacturing a wiring substrate.

### BACKGROUND ART

In recent years, multilayering of printed wiring boards has become widespread to increase the mounting density of the printed wiring boards for size reduction. Such multilayer printed wiring boards have been in use in many portable electronic apparatuses to reduce weight and size. These multilayer printed wiring boards have been required to have further reductions in the thicknesses of interlayer insulating layers and to still further weight reductions as wiring boards.

As a technique for satisfying such requirements, a method for manufacturing a multilayer printed wiring board using a coreless build-up method has been adopted. The coreless build-up method is a method of alternately laminating (building up) insulating layers and wiring layers for multilayering, without using a so-called core substrate. For the coreless build-up method, using a carrier-attached metal foil has been proposed to enable easy release of a support and a multilayer printed wiring board from each other. For example, Patent Literature 1 (JP2005-101137A) discloses a method for manufacturing a package substrate for semiconductor device mounting, the method including affixing an insulating resin layer to the carrier surface of a carrier-attached copper foil to form a support, forming a first wiring conductor on the superthin copper layer side of the carrier-attached copper foil by steps such as photoresist processing, pattern electrolytic copper plating, and resist removal, then forming build-up wiring layers, releasing the carrier-attached supporting substrate, and removing the superthin copper layer.

For the fining of an embedded circuit as shown in Patent Literature 1, a carrier-attached metal foil in which the thickness of a metal layer is 1 µm or less is desired. Therefore, it has been proposed to use a vapor phase method, such as sputtering, to form a metal layer and achieve a reduction in the thickness of the metal layer. For example, Patent Literature 2 (WO2017/150283) discloses a carrier-attached copper foil in which a release layer, an antireflection layer, and a superthin copper layer (for example, a film thickness of 300 nm) are formed on a carrier such as a glass sheet by sputtering. Patent Literature 3 (WO2017/150284) discloses a carrier-attached copper foil in which intermediate layers (for example, an adhesion metal layer and a release-assisting layer), a release layer, and a superthin copper layer (for example, a film thickness of 300 nm) are formed on a carrier such as a glass sheet by sputtering. Patent Literatures 2 and 3 also teach that intermediate layers composed of predetermined metals are interposed, thus providing excellent stability of the mechanical release strength of the carrier, and that the antireflection layer exhibits a desirable dark color, thus improving visibility in image inspection (for example, automatic image inspection (AOI)).

Especially, with still further size reduction and power saving of electronic devices, there is a growing need for the high integration and thinning of semiconductor chips and printed wiring boards. As next-generation packaging techniques for satisfying such a need, the adoption of fan-out wafer level packaging (FO-WLP) and panel level packaging (PLP) has been studied in recent years. The adoption of the coreless build-up method has also been studied for FO-WLP and PLP. One such method is a method referred to as a redistribution layer-first (RDL-first) method in which a wiring layer and, if necessary, a build-up wiring layer are formed on a coreless support surface, then chips are mounted and sealed, and subsequently the support is released. For example, Patent Literature 4 (JP2015-35551A) discloses a method for manufacturing a semiconductor apparatus, the method including forming a metal release layer on the main surface of a support composed of glass or a silicon wafer, forming an insulating resin layer on the metal release layer, forming a redistribution layer including build-up layers on the insulating resin layer, mounting and sealing semiconductor integrated circuits on the redistribution layer, exposing the release layer by the removal of the support, exposing secondary mounting pads by the removal of the release layer, and forming solder bumps on the surfaces of the secondary mounting pads, and performing secondary mounting.

Meanwhile, when a carrier is released from a wiring layer-attached carrier prepared using a method such as the coreless build-up method, the wiring layer may bend greatly to cause disconnection and peeling off, resulting in a decrease in the connection reliability of the wiring layer. Accordingly, methods for removing a carrier that address such a problem have been proposed. For example, Patent Literature 5 (JP2020-119952A) discloses a method for removing a carrier from a work (including, for example, a wiring layer in contact with a temporary adhesive layer, a plurality of chips bonded to the wiring layer, and a mold layer sealing each chip) provided on the surface of the carrier via the temporary adhesive layer. The method disclosed in Patent Literature 5 is to enable easy removal of the carrier from the work by forming a step portion where the bottom surface side of the carrier protrudes sideways compared to the top surface side of the carrier on which the work is provided, and applying a downward force to the step portion while the work is maintained from above. Patent Literature 6 (WO2018/173807) discloses a method for manufacturing a wiring board, in which while a composite laminate (including a support, a release layer, and a multilayer wiring board) is caused to adhere to a stage, the support or the multilayer wiring board is released from the release layer to form a predetermined convex curved surface. Such a method is to prevent the occurrence of defects, such as a cracking of the support and a crack and disconnection of the multilayer wiring board, and enable stable release.

### CITATION LIST

### PATENT LITERATURE

Patent Literature 1: JP2005-101137A
Patent Literature 2: WO2017/150283
Patent Literature 3: WO2017/150284
Patent Literature 4: JP2015-35551A
Patent Literature 5: JP2020-119952A
Patent Literature 6: WO2018/173807

### SUMMARY OF INVENTION

However, for the conventional method for manufacturing a wiring substrate, there are cases such as a case where the carrier may be difficult to release depending on the thickness of the wiring substrate (for example, a resin-containing layer including a wiring layer, a semiconductor device (chip), and a resin layer), and a case where a dedicated apparatus or a complicated process may be required to release the carrier. There is room for improvement from the viewpoint of easy and reliable release of the carrier.

The present inventors have now found that a wiring substrate can be manufactured by making a predetermined cut in a laminated sheet, which includes a carrier, a release layer, and a metal layer in order, to divide the metal layer and the release layer into a central portion and a peripheral portion, and by inserting a thin piece at a predetermined angle from the cut to form a gap between the metal layer and the carrier, thus easily and reliably releasing a carrier.

Therefore, an object of the present invention is to provide a method for manufacturing a wiring substrate that can easily and reliably release a carrier.

The present invention provides the following aspects:
[Aspect 1]
   A method for manufacturing a wiring substrate, comprising the steps of:
   providing a laminated sheet that includes a release layer and a metal layer in order on a carrier;
   forming a cut in the laminated sheet from a surface of the laminated sheet opposite to the carrier so that the cut passes through an inside of an outer edge portion of the laminated sheet when the laminated sheet is seen in a planar view and so that the cut penetrates the metal layer and the release layer when the laminated sheet is seen in a cross-sectional view, and dividing the metal layer and the release layer into a central portion and a peripheral portion with the cut as a boundary; and
   inserting a thin piece from the cut toward the central portion side of the metal layer or the release layer to form a gap between the metal layer and the carrier in which an insertion angle of the thin piece with respect to a main surface of the carrier is greater than 0° when the laminated sheet is seen in the cross-sectional view.
[Aspect 2]
   A method for manufacturing a wiring substrate, comprising the steps of:
   providing a laminated sheet that includes a release layer and a metal layer in order on a carrier;
   forming a cut in the laminated sheet from a surface of the laminated sheet opposite to the carrier so that the cut passes through an inside of an outer edge portion of the laminated sheet when the laminated sheet is seen in a planar view and so that the cut penetrates the metal layer and the release layer when the laminated sheet is seen in a cross-sectional view, and dividing the metal layer and the release layer into a central portion and a peripheral portion with the cut as a boundary; and
   inserting a thin piece from the cut toward the central portion side of the metal layer or the release layer to form a gap between the metal layer and the carrier in which an insertion angle of the thin piece with respect to a main surface of the carrier is greater than 0° when the laminated sheet is seen in the cross-sectional view,
   wherein the carrier is a single-crystal silicon carrier having a notch or an orientation flat on a periphery, and in the step of forming the cut, the cut is made so that when an angle θ is defined right-handed, or clockwise, starting from a half line that extends from a center of the single-crystal silicon carrier to a midpoint of the notch or the orientation flat, a direction of development of external stress falls within a range of 1° <θ < 89°.
[Aspect 3]
   The method for manufacturing the wiring substrate according to Aspect 1 or 2, further comprising the step of moving the thin piece along the cut, starting from the gap formed, to enlarge the gap.
[Aspect 4]
   The method for manufacturing the wiring substrate according to Aspect 3, further comprising the step of applying, after the enlargement of the gap, a force to the laminated sheet in a direction that causes the carrier and the metal layer to separate to release the metal layer from the carrier with the gap as a trigger.
[Aspect 5]
   The method for manufacturing the wiring substrate according to any one of Aspects 1 to 4, wherein the cut is formed so that at least a part of the carrier is unpenetrated when the laminated sheet is seen in a cross-sectional view.
[Aspect 6]
   The method for manufacturing the wiring substrate according to any one of Aspects 1 to 5, wherein the cut has a width of 0.01 mm or more and 20 mm or less.
[Aspect 7]
   The method for manufacturing the wiring substrate according to any one of Aspects 1 to 6, wherein the thin piece is a cutting blade, and the cutting blade is one of a flat blade, a triangular blade, a square blade, a circular blade, and a rotary blade.
[Aspect 8]
   The method for manufacturing the wiring substrate according to any one of Aspects 1 to 7, wherein the cut is formed in a linear pattern so that the peripheral portion surrounds the central portion when the laminated sheet is seen in a planar view.
[Aspect 9]
   The method for manufacturing the wiring substrate according to any one of Aspects 3 to 8, wherein the thin piece is moved over a part or an entire length of the cut.
[Aspect 10]
   The method for manufacturing the wiring substrate according to any one of Aspects 4 to 9, wherein the metal layer is released in a state where an outer edge portion of the carrier or the laminated sheet is gripped or supported.
[Aspect 11] The method for manufacturing the wiring substrate according to any one of Aspects 1 to 10, wherein the insertion angle is greater than 0.1° and less than or equal to 60°.
[Aspect 12]
   The method for manufacturing the wiring substrate according to any one of Aspects 1 to 11, wherein an insertion width of the thin piece into the laminated sheet in a formation of the gap is 0.1 mm or more.
[Aspect 13]
   The method for manufacturing the wiring substrate according to any one of Aspects 1 to 12, wherein the thin piece is composed of at least one selected from the group consisting of a ferrous material, a nonferrous metal, ceramic, and diamond.
[Aspect 14]
   The method for manufacturing the wiring substrate according to any one of Aspects 1 to 13, wherein the laminated sheet further includes a resin-containing layer on a surface of the metal layer opposite to the release layer.
[Aspect 15]
   The method for manufacturing the wiring substrate according to Aspect 14, wherein the resin-containing layer includes at least one selected from the group consisting of a wiring layer, a semiconductor device, and a resin layer.
[Aspect 16]
   The method for manufacturing the wiring substrate according to Aspect 14 or 15, wherein the resin-containing layer has a thickness of 1000 µm or less.
[Aspect 17]
   The method for manufacturing the wiring substrate according to any one of Aspects 14 to 16, wherein the insertion of the thin piece in a formation of the gap is performed into the resin-containing layer.

### BRIEF DESCRIPTION OF DRAWINGS

Figure 1A is a process flow chart showing in a schematic cross-sectional view an example of a method for manufacturing the wiring substrate according to the present invention, and corresponds to the initial step (steps (i) and (ii)).
Figure 1B is a process flow chart showing steps corresponding to Figure 1A in a schematic top view seen from the surface of a laminated sheet opposite to a carrier.
Figure 2A is a process flow chart showing in a schematic cross-sectional view an example of a method for manufacturing the wiring substrate according to the present invention, and corresponds to the mid-term step (steps (iii) and (iv)) following the step shown in Figure 1A.
Figure 2B is a process flow chart showing steps corresponding to Figure 2A in a schematic top view seen from the surface of a laminated sheet opposite to a carrier.
Figure 3 is a process flow chart showing in a schematic cross-sectional view an example of a method for manufacturing the wiring substrate according to the present invention, and corresponds to the later step (steps(v) and(vi)) following the step shown in Figure 2A.
Figure 4 is a process flow chart showing in a schematic cross-sectional view an example of forming a gap using a machine tool in a laminated sheet with a full mold structure.
Figure 5 is a process flow chart showing in a schematic cross-sectional view an example of a conventional method for manufacturing a wiring substrate, and corresponds to the first half step (steps (i) and (ii)).
Figure 6 is a process flow chart showing in a schematic cross-sectional view an example of the conventional method for manufacturing a wiring substrate, and corresponds to the second half step (steps (iii) and (iv)) following the step shown in Figure 5.
Figure 7 is a view for explaining the diameter, blade thickness, and blade angle of a rotary blade.
Figure 8 is a schematic cross-sectional view showing an example of a method for releasing the carrier.
Figure 9A is a process flow chart showing in a top view a case where when the carrier is a silicon wafer having a notch, a direction in which external stress due to the formation of the cut or the release of the carrier develops matches cleavage orientation, and the silicon wafer cracks, and Figure 9A corresponds to the first half step (steps (i) and (ii)).
Figure 9B is a process flow chart showing in a top view a case where when the carrier is the silicon wafer having a notch, a direction in which external stress due to the formation of the cut or the release of the carrier develops matches the cleavage orientation, and the silicon wafer cracks, and Figure 9B corresponds to the second half step (steps (iii) and (iv)) following the step shown in Figure 9A.
Figure 10A is a process flow chart showing in a top view a case where when the carrier is a silicon wafer having a notch, a direction in which external stress due to the formation of the cut or the release of the carrier develops does not match the cleavage orientation, and the cracking of the silicon wafer is inhibited, and Figure 10A corresponds to the first half step (steps (i) and (ii)).
Figure 10B is a process flow chart showing in a top view a case where when the carrier is a silicon wafer having a notch, a direction in which external stress due to the formation of the cut or the release of the carrier develops does not match the cleavage orientation, and the cracking of the silicon wafer is inhibited, and Figure 10B corresponds to the second half step (steps (iii) and (iv)) following the step shown in Figure 10A.
Figure 11 is a view showing the cleavage orientation of the carrier when the carrier is a silicon wafer having an orientation flat.

### DESCRIPTION OF EMBODIMENTS

### Method for Manufacturing wiring substrate

The present invention relates to a method for manufacturing a wiring substrate. The method of the present invention comprises the steps of: (1) provision of a laminated sheet, (2) formation of a cut, (3) formation of a gap, (4) enlargement of the gap, optionally performed, and (5) release of a carrier, optionally performed.

Each of the steps (1) to (5) will be described below with reference to the drawings.

### (1) Provision of Laminated Sheet

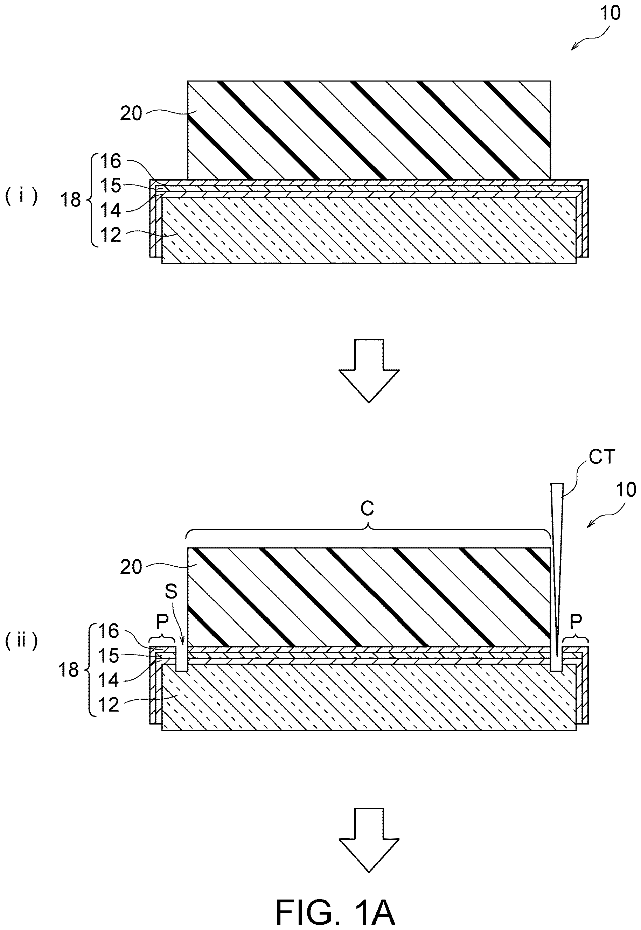

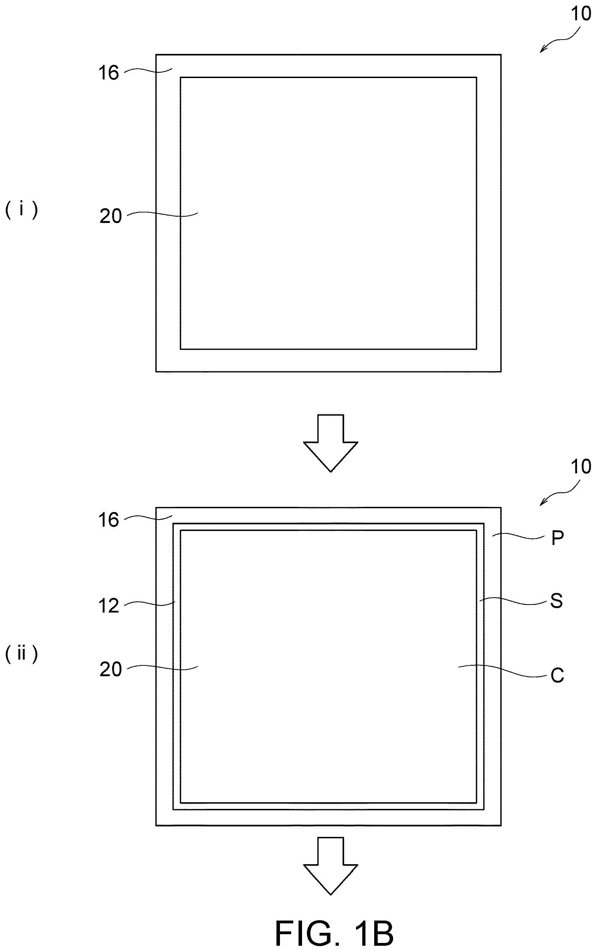

Figures 1 to 3 show an example of a method for manufacturing the wiring substrate according to the present invention. First, as shown in Figure 1A(i), a laminated sheet 10 is provided including a release layer 15 and a metal layer 16 in order on a carrier 12. The release layer 15 is a layer that is provided on the carrier 12 and contributes to the release of the carrier 12 and the metal layer 16 from each other. The metal layer 16 is a layer composed of metal provided on the release layer 15.

The laminated sheet 10 may further include an intermediate layer 14 between the carrier 12 and the release layer 15. Each of the intermediate layer 14, the release layer 15, and the metal layer 16 may be a single layer composed of one layer or a multilayer composed of two or more layers.

The carrier 12 may be composed of any one of glass, ceramic, silicon, resin, and metal, but is preferably a substrate containing silicon or a glass substrate. The substrate containing silicon may be any substrate as long as the substrate contains Si as an element, and a SiOz substrate, a SiN substrate, a Si single crystal substrate, a Si polycrystalline substrate, or the like can be applied. A glass carrier, a single-crystal silicon substrate, or a polycrystalline silicon substrate is more preferred. According to a preferred aspect of the present invention, the carrier 12 has a disk shape with a diameter of 100 mm or more, and more preferably a disk shape with a diameter of 200 mm or more and 450 mm or less. According to another preferred aspect of the present invention, the carrier 12 has a rectangular shape with a short side of 100 mm or more, and more preferably a short side of 150 mm or more and 650 mm or less. The rectangular carrier 12 may have a roll shape with its long side sufficiently longer than its short side, and preferably has a long side of 200 mm or more and 650 mm or less.

As shown in Figures 1A(i) and 1 B(i), the laminated sheet 10 may further include a resin-containing layer 20 on the surface of the metal layer 16 opposite to the release layer 15. The resin-containing layer 20 preferably includes at least one selected from the group consisting of a wiring layer, a semiconductor device, and a resin layer (mold resin layer). For example, the resin-containing layer 20 may include at least a resin layer. More preferably, the resin-containing layer 20 includes a wiring layer, a semiconductor device provided on the wiring layer, and a resin layer that surrounds at least the semiconductor device. The resin layer may have a structure that surrounds only the semiconductor device (flange mold structure), or may have a structure that surrounds both the semiconductor device and the wiring layer (full mold structure). In any case, the resin-containing layer 20 can be formed by the same method as the conventional method for manufacturing a wiring substrate. Note that the semiconductor devices described above include those having device functions, such as those of an integrated circuit and a sensor.

The thickness of the resin-containing layer 20 is preferably 1000 µm or less, more preferably 10 µm or more and 500 µm or less, further preferably 50 µm or more and 400 µm or less, and particularly preferably 70 µm or more and 300 µm or less. Thus, the resin-containing layer 20 has excellent heat dissipation performance while the size and weight of the wiring board are reduced. Even when the resin-containing layer 20 is this thin, the carrier 12 can be reliably released according to the present invention.

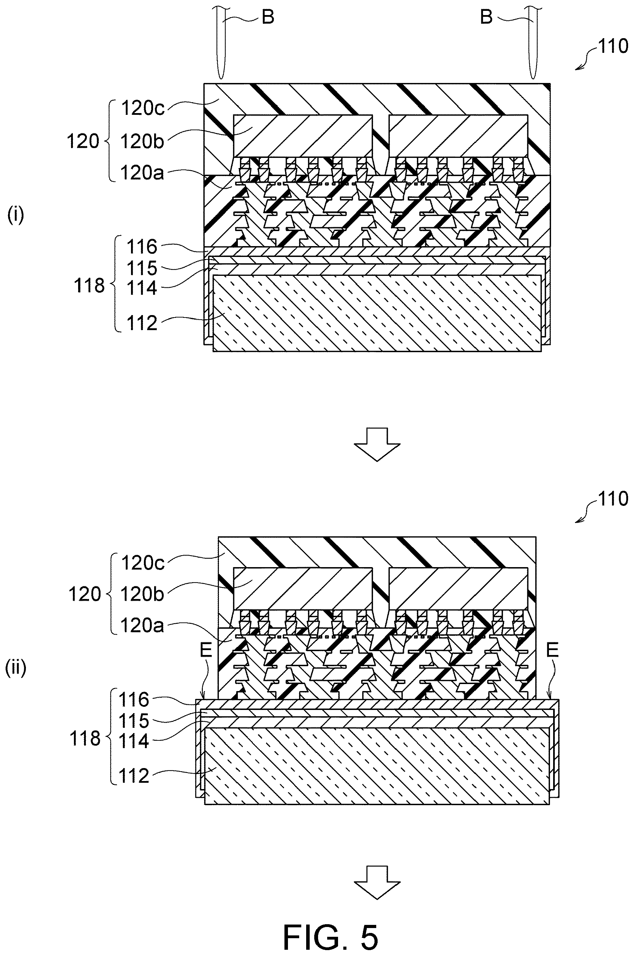

The laminated sheet 10 can be provided, for example, in the following manner. First, a carrier-attached metal foil 18 is provided including an optionally provided intermediate layer 14 (that is, an optional layer), the release layer 15, and the metal layer 16 on the carrier 12. Then, a first wiring layer is formed on the surface of the metal layer 16. Thereafter, the resin-containing layer 20 is formed on the basis of the first wiring layer. The formation of the first wiring layer and the construction of the resin-containing layer 20 should be carried out by a known method, and for example, the coreless build-up method described above can be preferably adopted. If necessary, a semiconductor device 120b may be mounted on the first wiring layer (or on a wiring layer 120a constructed on the basis of the first wiring layer) (see Figure 5(i)). When the electrode of the semiconductor device 120b is bonded to the wiring of the wiring layer 120a, the semiconductor device 120b is electrically connected to the wiring layer 120a. The semiconductor device 120b is preferably covered with a resin layer 120c after being mounted on the wiring layer 120a. Herein, the carrier 12, the intermediate layer 14 (when present), the release layer 15, and the metal layer 16 may be collectively referred to as the "carrier-attached metal foil 18". A preferred aspect of the carrier-attached metal foil 18 will be described later.

### (2) Formation of Cut

A cut S is made in the provided laminated sheet 10 from the surface opposite to the carrier 12. As shown in Figure 1 B(ii), the cut S is made to pass through the inside of the outer edge portion of the laminated sheet 10 when the laminated sheet 10 is seen in a planar view. At this time, as shown in Figure 1A(ii), the cut S is made to penetrate the metal layer 16, the release layer 15, and the intermediate layer 14 (when present) when the laminated sheet 10 is seen in a cross-sectional view. Making such a cut S in the laminated sheet 10 brings the metal layer 16, the release layer 15, and the intermediate layer 14 (when present) into a state where the layers are divided into a central portion C and a peripheral portion P with the cut S as a boundary (see Figures 1A(ii) and 1 B(ii)). It is thereby possible to form a gap to be described later from the cut S and to easily and reliably release the carrier 12 (release the metal layer 16).

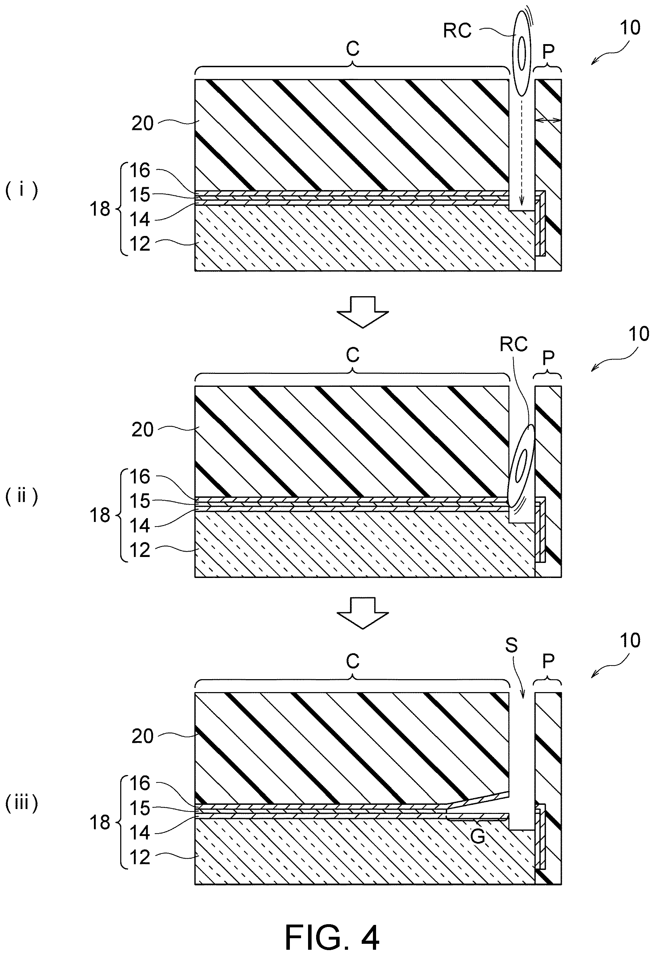

The method for forming the cut S should be performed by adopting a known method and is not particularly limited. For example, the cut S can be formed in the laminated sheet 10 using a cutting tool such as a cutter CT as shown in Figure 1A(ii), or a machine tool such as a cutting blade. In the case of forming the cut S using a machine tool, it is preferable to perform alignment for the cut S by viewing the laminated sheet 10 from the horizontal direction with a camera or the like. Here, Figure 4 shows an example of processing using a machine tool on the laminated sheet 10 with a full mold structure (a structure in which the resin layer constituting the resin-containing layer 20 surrounds both the semiconductor device and the wiring layer). As shown in Figures 4(i) to 4(iii), when the cut S and the gap G to be described later are formed in the laminated sheet 10 with the full mold structure using a machine tool, it is desirable to determine a processing position (a distance from the side end face of the resin layer) by viewing the laminated sheet 10 from the horizontal direction with a camera (not shown) (see Figure 4(i)), and to form the cut S and the gap G in the determined processing position using a machine tool (for example, a rotary blade RC) (see Figures 4(ii) and 4(iii)). In the case of processing the laminated sheet 10 with a flange mold structure (a structure in which the resin layer constituting the resin-containing layer 20 surrounds only the semiconductor device), it is desirable to view the vicinity of the side end face of the resin layer with a camera and to form the cut S along the side end face of the resin layer (see Figure 1A(ii)).

As shown in Figure 1A(ii), the cut S is preferably formed so that at least a part of the carrier 12 is unpenetrated when the laminated sheet 10 is seen in a cross-sectional view. This makes it possible to insert and move the thin piece with the carrier 12 as a guide in a gap formation step and a gap enlargement step to be described later, and to more easily and reliably release the carrier 12 (release the metal layer 16).

The width of the cut S (the width in the surface direction of the laminated sheet 10) is preferably 0.01 mm or more and 20 mm or less, more preferably 0.05 mm or more and 15 mm or less, and further preferably 0.2 mm or more and 10 mm or less. By setting this range, it is possible to more accurately insert the thin piece into an intended location between the release layer 15 and the metal layer 16 in the gap formation step and the gap enlargement step to be described later, and to smoothly perform the subsequent release step. Moreover, an effect is exerted to prevent unnecessary scratches in the release layer 15, the metal layer 16, and the like. Note that the cut S is preferably formed in a direction substantially perpendicular to the main surface of the carrier 12 (in the thickness direction of the laminated sheet 10). That is, it is desirable to insert a blade of a cutting tool or the like into the surface of the laminated sheet 10 opposite to the carrier 12 in a direction substantially perpendicular to the main surface of the carrier 12 (for example, within the range of 90° ± 5°).

The cut S is preferably formed in a linear pattern so that the peripheral portion P surrounds the central portion C when the laminated sheet 10 is seen in a planar view. The linear pattern may be formed in a curved line, and for example, when the laminated sheet 10 has a disk shape, the cuts S may be formed in a circular pattern. In the example shown in Figure 1 B(ii), the cut S is formed in a rectangular pattern (four-sided linear pattern) by processing at a predetermined separation distance from the outer edge portion (four sides) of the rectangular laminated sheet 10. However, when the rectangular laminated sheet 10 is used, it is not always necessary to form the cut S in the four-sided linear pattern described above, and the cut S may be formed in a linear pattern with one or more and three or less sides to the extent that a gap sufficient for inserting the thin piece can be formed.

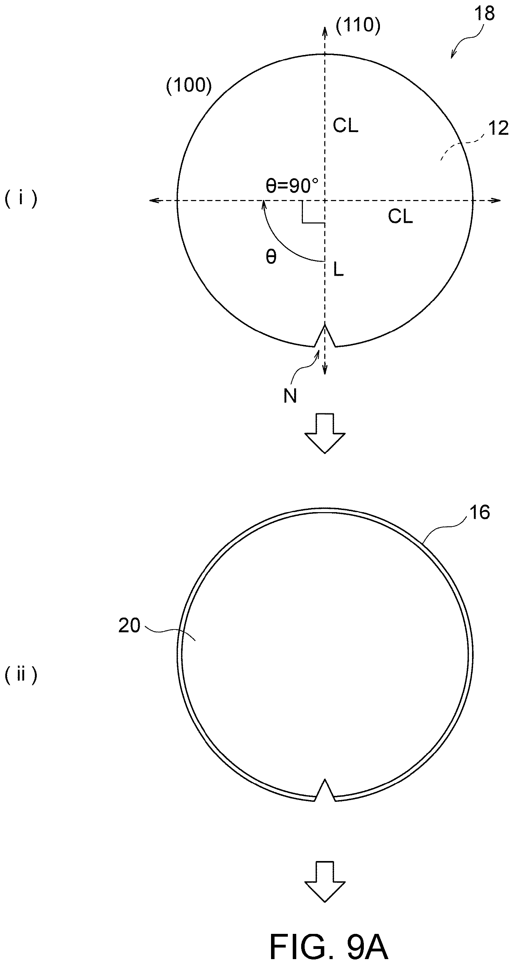

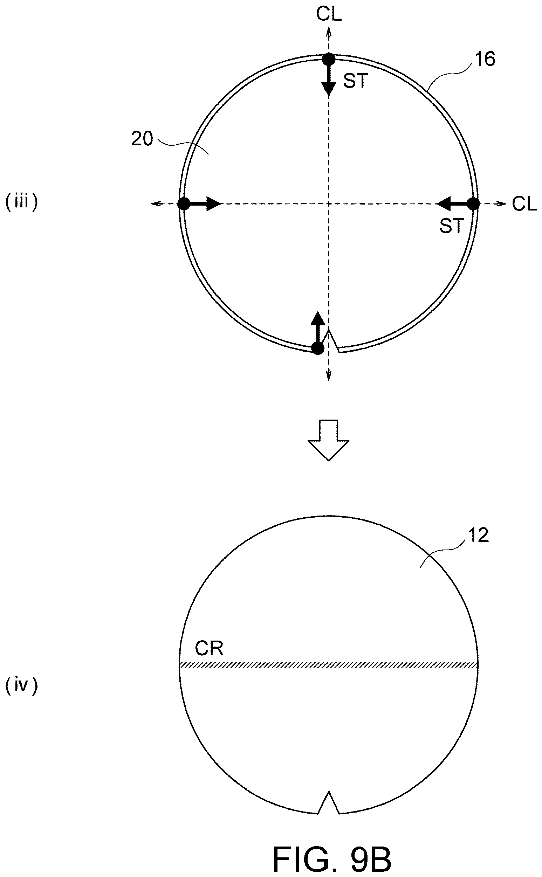

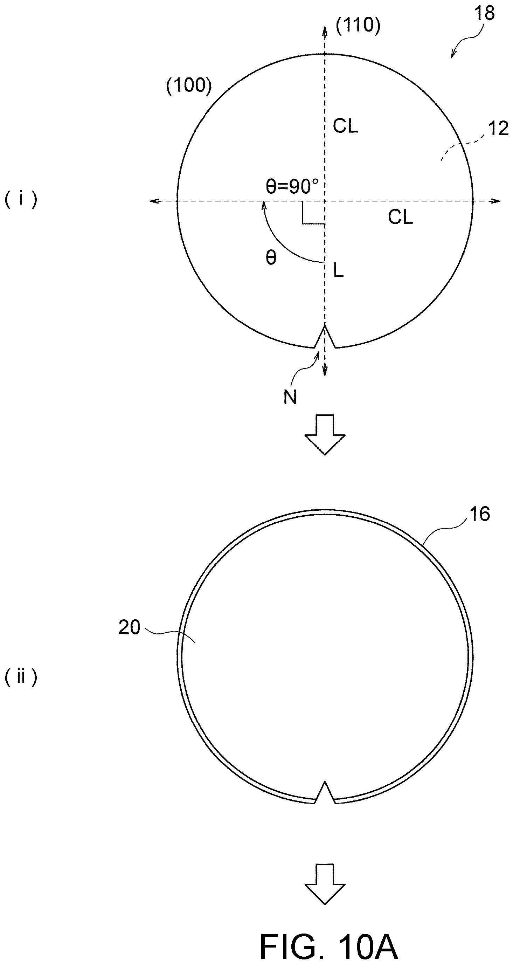

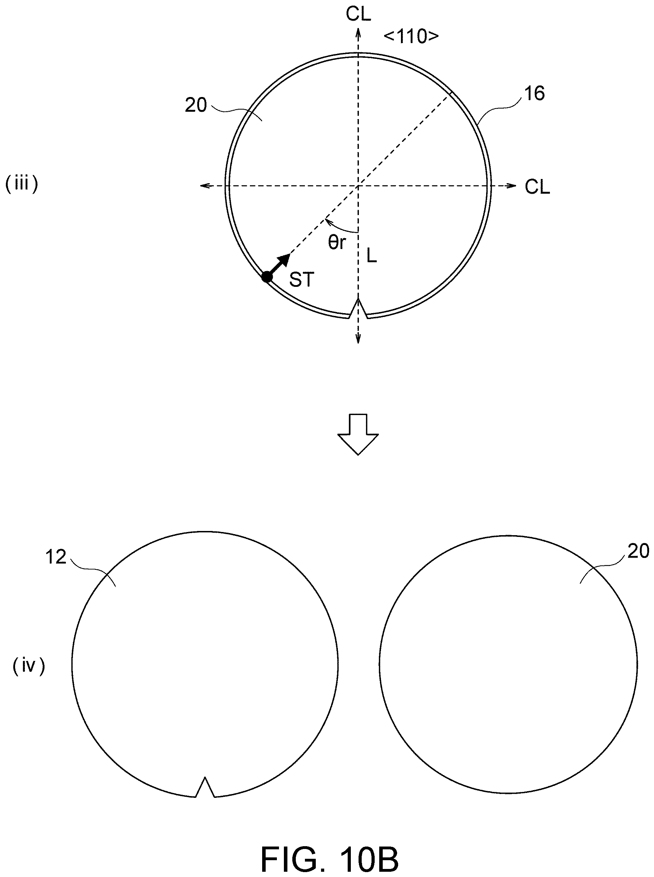

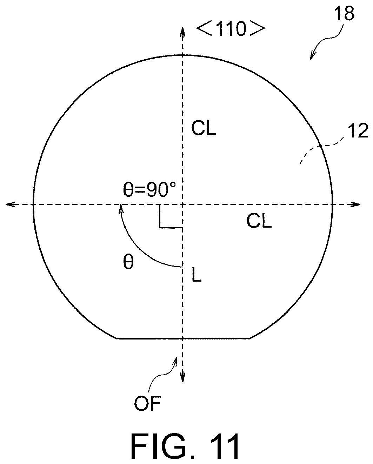

When the carrier is a single-crystal silicon carrier in the step of forming this cut, the development direction of the cut S is preferably noted. Figures 9A, 9B, 10A, and 10B show the cut formation step and/or a carrier release step to be described later when the carrier 12 of the carrier-attached metal foil 18 is a single-crystal silicon carrier. In the steps shown in Figures 9A to 10B, the carrier-attached metal foil 18 in which the carrier 12 is a single-crystal silicon carrier is provided (Figures 9A(i) and 10A(i)), the resin-containing layer 20 is formed on the metal layer 16 of the carrier-attached metal foil 18 (Figures 9A(ii) and 10A(ii)), and then the cut S is formed, and/or the carrier 12 is released (Figures 9B(iii) and (iv) and 10B(iii) and (iv)). Note that the single-crystal silicon carrier typically has, on its periphery, a notch N shown in Figures 9A(i) and 10A(i) or an orientation flat OF shown in Figure 11 to indicate a reference point for crystal orientation. In general, an orientation flat is formed when the diameter of single-crystal silicon is 200 mm or less, and a notch is formed when the diameter is 200 mm or more. Hereinafter, the notch N and the orientation flat OF may be collectively referred to as a "notch or the like".

As shown in Figures 9B(iii) and 9B(iv), when the cut S is formed in a direction where a direction in which external stress ST develops matches cleavage orientation CL, there is a possibility of breakage in the silicon carrier, such as the occurrence of a crack CR along the cleavage orientation CL, starting from the point to which the external stress ST is first applied. In order to inhibit such breakage in the silicon carrier due to cleavage, when the carrier 12 is a single-crystal silicon carrier, as shown in Figures 10B(iii) and 10B(iv), the external stress ST is preferably applied in a direction that does not match either direction of the cleavage orientation CL, on the x-axis (horizontal direction in the figure) and the y-axis (vertical direction in the figure) on the silicon carrier, to form the cut S in the carrier 12.

Therefore, according to the preferred aspect of the present invention, the carrier 12 is a single-crystal silicon carrier having a notch or the like on the periphery, and in the step of forming the cut S, when an angle θ is defined right-handed (clockwise) starting from a half line L that extends from the center of the single-crystal silicon carrier to the notch or the like, the cut is made so that the development direction of the external stress falls within the range of 1° <θ < 89°.

A more specific description will be provided. As shown in Figures 9A(i) and 10A(i), when the angle θ is defined right-handed (clockwise) starting from the half line L that extends from the center of the carrier 12 to the midpoint of the notch N or the orientation flat OF, values of θ at 0°, 90°, 180°, and 270° correspond to the cleavage orientation CL. Therefore, as shown in Figure 10B(iii), when θr represents the direction of the development of the external stress ST due to the cut, the cutting is preferably performed while the development direction of the external stress ST is maintained so that θr falls within the range of 1° < θr < 89°, and more preferably within the range of 5° < θr < 85°. The method of introducing a cut, which satisfies such a range of θr, can inhibit breakage in the carrier 12 that is composed of a silicon wafer. Particularly preferred ranges of θr during this cutting are θr = within 45 ± 5°, within 135 ± 5°, within 225 ± 5°, and within 315 ± 5°, right-handed starting from the half line L in this cutting. The wafer is least likely to cleave at these angles in the <100> direction of the crystal orientation of the silicon wafer, so that it is possible to form the cut S while effectively inhibiting breakage in the wafer by developing the external stress at these angles.

### (3) Formation of Gap

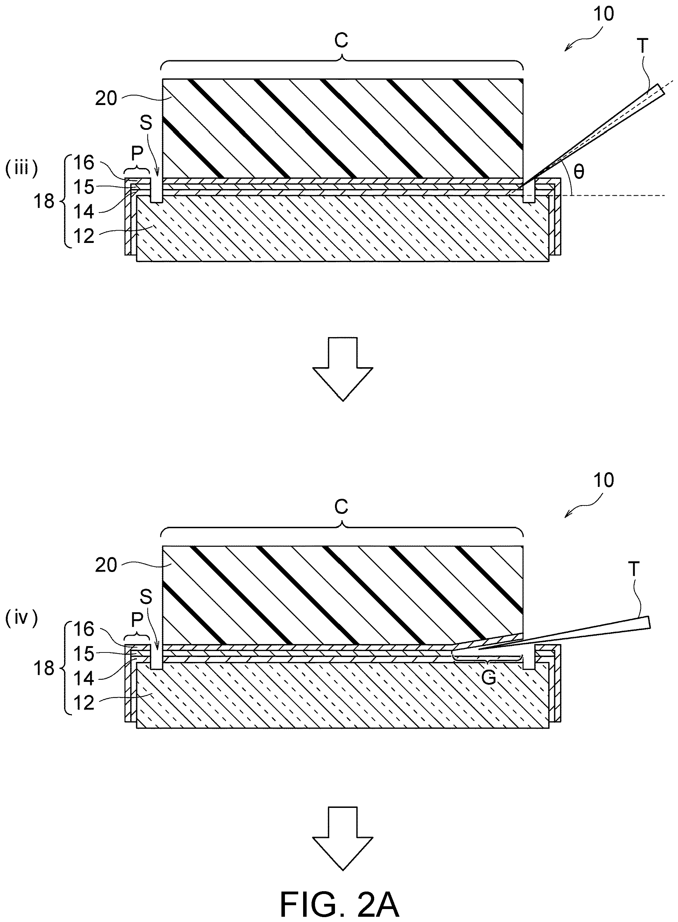

A thin piece T is inserted from the cut S into the laminated sheet 10 with the cut S formed therein toward the central portion C side of the resin-containing layer 20 (when present), the metal layer 16, the release layer 15 or the intermediate layer 14 (when present) (Figures 2A(iii) and 2B(iii)). At this time, as shown in Figure 2A(iii), an insertion angle θ of the thin piece T with respect to the main surface of the carrier 12 is made to exceed 0° when the laminated sheet 10 is seen in a cross-sectional view. Thus, the gap G can be formed between the metal layer 16 and the carrier 12 (Figure 2A(iv)), and the gap G can serve as a trigger for easy and reliable release of the carrier 12.

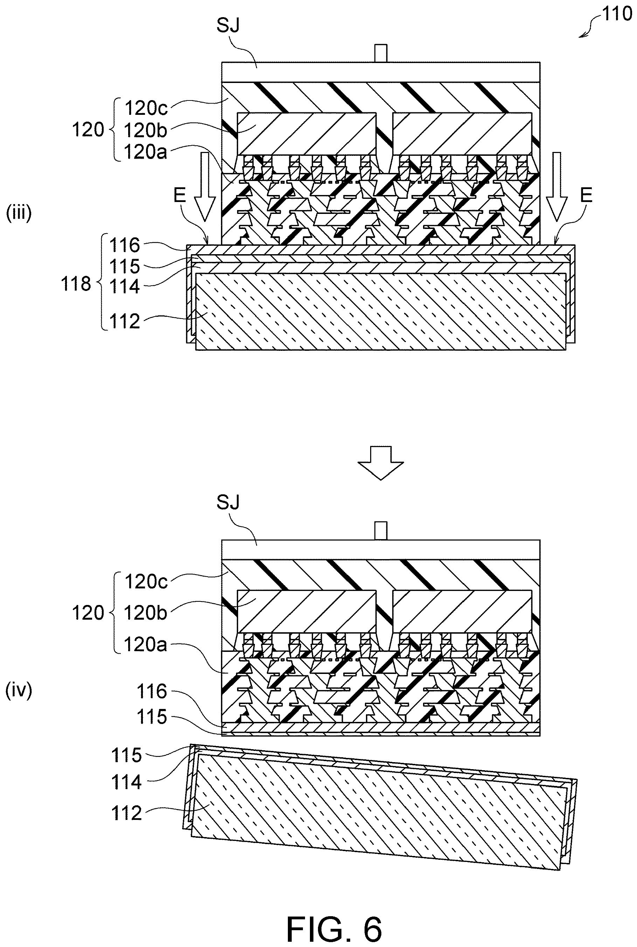

In recent years, in order to further reduce the thickness of a semiconductor package, a resin-containing layer has been made thinner by polishing a resin layer (mold resin) or the like. However, the conventional carrier release method as disclosed in Patent Literature 5 requires a step of holding a highly rigid resin-containing layer from above using a holding unit, and the method is not sufficiently compatible with such a thinner resin-containing layer, that is, a less rigid resin-containing layer. Figures 5 and 6 show an example of the conventional method for manufacturing a wiring substrate. In the conventional process shown in Figures 5 and 6, first, a laminated sheet 110 with a resin-containing layer 120 provided on a carrier-attached metal foil 118 is provided (Figure 5(i)). In this example, the carrier-attached metal foil 118 includes an intermediate layer 114, a release layer 115, and a metal layer 116 in order on a carrier 112. The resin-containing layer 120 includes a wiring layer 120a, a semiconductor device 120b, and a resin layer 120c. Then, a cut reaching the carrier-attached metal foil 118 is made from the resin-containing layer 120 side of the provided laminated sheet 110 using a blade B, and the outer edge portion outside the cut in the resin-containing layer 120 is removed to form an extending portion E (Figure 5 (ii)). Subsequently, with the resin-containing layer 120 fixed by a suction jig SJ, a force is applied to the formed extending portion E in the direction of pulling the carrier 112 away from the resin-containing layer 120 (Figure 6(iii)). Thus, the carrier 112 and the intermediate layer 114 are released from the resin-containing layer 120 at the position of the release layer 115 (Figure 6(iv)).

However, according to the findings of the present inventors, it has been found that in such a conventional method, the carrier 112 may be difficult to release when the resin-containing layer 120 is as thin as 300 µm or less. One of the factors contributing to this is as follows. That is, in the carrier release method shown in Figures 5 and 6, when the thickness of the resin-containing layer 120 is as large as more than 300 µm, it is considered that the residual stress at the interface between the resin-containing layer 120 and the carrier-attached metal foil 118 is large, and the release of the carrier 112 and the like is promoted by this residual stress. On the other hand, when the thickness of the resin-containing layer 120 is as small as 300 µm or less, it is considered that the residual stress at the interface between the resin-containing layer 120 and the carrier-attached metal foil 118 is small, and as a result, the release of the carrier 112 and the like are less likely to be promoted.

In contrast, in the present invention, the gap G is formed between the metal layer 16 and the carrier 12 (typically, the release layer 15 or its vicinity), whereby it is possible to reliably release the carrier 12 (release the metal layer 16) with the gap G as a trigger. Specifically, in the manufacture of a semiconductor package, the metal layer 16 and the carrier 12 have release strength in between at a certain level or higher so that the carrier 12 as a support is not unintentionally released. In this regard, by forming the gap G, where the metal layer 16 and the carrier 12 are partially released, a stress concentration portion to serve as the starting point of the release can be formed between the metal layer 16 and the carrier 12 in the release step, which is a subsequent step. It is thereby possible to reliably release the carrier 12 that has served as the support, regardless of the thickness of the resin-containing layer 20. Further, in the method of the present invention, the carrier 12 can be released by a simple method of forming the cut S and the gap G without requiring a dedicated apparatus or a complicated process. As thus described, a wiring substrate can be manufactured by making the predetermined cut S in the laminated sheet 10, which includes the carrier 12, the release layer 15, and the metal layer 16 in order, to divide the metal layer 16 and the release layer 15 into the central portion C and the peripheral portion P, and by inserting the thin piece T at the predetermined angle θ from the cut S to form the gap G between the metal layer 16 and the carrier 12, thus easily and reliably releasing the carrier 12.

As shown in Figure 2A(iii), when the laminated sheet 10 is seen in a cross-sectional view, at a location where the tip of the thin piece T (or an imaginary line passing through the tip) is in contact with the surface of the carrier 12, the insertion angle θ of the thin piece T with respect to the main surface of the carrier 12 is defined as an angle formed by the tip of the thin piece T and the surface of the carrier 12. The reason for this definition is that the thin piece T does not behave as a rigid body, but may flex like an elastic body. The insertion angle θ is more than 0°, preferably more than 0.1° and 60° or less, more preferably 1° or more and 58° or less, further preferably 2° or more and 55° or less, particularly preferably 3° or more and 50° or less, and most preferably 5° or more and 45° or less. By inserting the thin piece T into the laminated sheet 10 at such an angle, the thin piece T is inserted into a location of the weakest adhesion (typically, the release layer 15 or its vicinity) among the layers constituting the laminated sheet 10, thus effectively forming the gap G. Further, it is preferable to apply a vertical stress to the release layer 15 or its vicinity (for example, to rub the periphery of the release layer 15 with the thin piece T) during the insertion of the thin piece T, whereby the gap G can be formed more efficiently.

In the formation of the gap G, the insertion width of the thin piece T into the laminated sheet 10 is preferably 0.1 mm or more, more preferably 0.5 mm or more, and further preferably 1 mm or more. Herein, the insertion width means the distance from the cut S to the innermost portion of the gap G (which can also be referred to as the depth of the gap G). With the insertion width as described above, the gap G can further promote the release of the carrier 12. The upper limit of the insertion width can be appropriately determined according to the size of the laminated sheet 10. While there is no specific limitation, 20 mm may be mentioned as a guideline for the upper limit.

When the laminated sheet 10 further includes the resin-containing layer 20, in the formation of the gap G, the thin piece T (for example, the rotary blade RC) may be inserted into the resin-containing layer 20 (the central portion C side, see Figure 4(ii)). The release strength between the metal layer 16 and the resin-containing layer 20 is typically greater than the release strength between the carrier 12 and the metal layer 16. Therefore, by inserting the thin piece T into the resin-containing layer 20, as shown in Figure 4(iii), the metal layer 16 is lifted together with the resin-containing layer 20 and is partially pulled away from the carrier 12. As a result, the gap G can be formed between the metal layer 16 and the carrier 12.

From the viewpoint of the formability of the gap G, the thickness of the thin piece T is typically 2 mm or less, more typically 0.1 mm or more and 1 mm or less. A spring deflection limit Kb_{0.1} of the thin piece T measured by a repeated deflection test in accordance with the Japanese Industrial Standards (JIS) H3130-2012 is preferably 100 N/mm² or more and 1500 N/mm² or less, more preferably 200 N/mm² or more and 1000 N/mm² or less, and further preferably 300 N/mm² or more and 800 N/mm² or less. Moreover, the static modulus of elasticity of the thin piece T measured in accordance with JIS R1602-1995 is preferably 30 GPa or more and 800 GPa or less, more preferably 80 GPa or more and 300 GPa or less, and further preferably 100 GPa or more and 200 GPa or less. Using the thin piece T having such rigidity makes it easier to form the gap G. The thin piece T may be the same as or different from the cutting tool or machine tool used to form the cut T described above.

The thin piece T is preferably composed of at least one selected from the group consisting of a ferrous material, a nonferrous metal, ceramic, and diamond, and more preferably composed of tungsten or stainless steel. Preferable examples of the ferrous material include stainless steel, carbon tool steel (such as SK120 specified in JIS G4401-2009), alloy tool steel (such as SKS7 specified in JIS G4404-2015, in which a small amount of tungsten, chromium, vanadium, or the like is added to carbon tool steel), and high-speed tool steel (such as SKH51 specified in JIS G4403-2015, in which a large amount of tungsten, chromium, vanadium, molybdenum, or the like is added to carbon tool steel). Preferred examples of the nonferrous metal include tungsten and a super-hard alloy (an alloy made by sintering powder of a hard metal carbide such as tungsten carbide). Preferred examples of the ceramic include zirconium oxide.

The thin piece T is preferably a cutting blade because the gap G can be easily formed. The shape of the cutting blade may be any one of a flat blade, a triangular blade, a square blade, a circular blade, and a rotary blade. However, among these, a cutting blade with an arc or curved tip is more preferable, and a rotary blade is particularly preferred. Using a rotary blade (sometimes referred to as a rotary cutter, a slit cutter, or a round knife) facilitates the insertion of the blade into the laminated sheet 10 at a certain insertion angle θ, and inserting the blade into the laminated sheet 10 so that the blade is pressed while being rotated enables smooth formation of the gap G, thus effectively inhibiting breakage in the resin-containing layer 20.

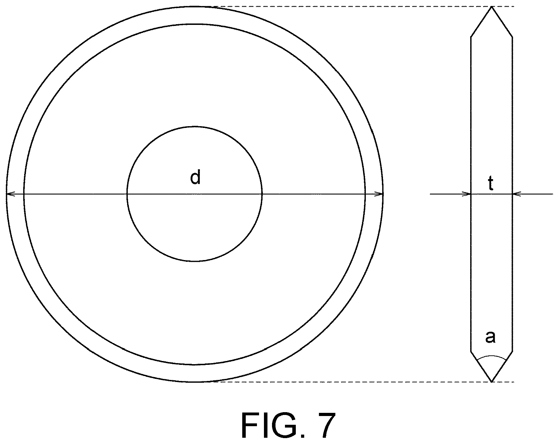

Figure 7 shows a schematic diagram of the rotary blade. As shown in Figure 7, the rotary blade preferably has a diameter d, a blade thickness t, and a blade angle a within predetermined ranges from the viewpoint of the formability of the gap G. That is, the diameter d of the rotary blade is preferably 5 mm or more and 150 mm or less, more preferably 10 mm or more and 100 mm or less, and further preferably 18 mm or more and to 60 mm or less. The blade thickness t of the rotary blade is preferably 0.1 mm or more and 5 mm or less, more preferably 0.2 mm or more and 3 mm or less, and further preferably 0.3 mm or more and 1 mm or less. The blade angle a of the rotary blade is preferably 10° or more and 50° or less, more preferably 15° or more and 40° or less, and further preferably 20° or more and 30° or less.

### (4) Enlargement of Gap (Optional Step)

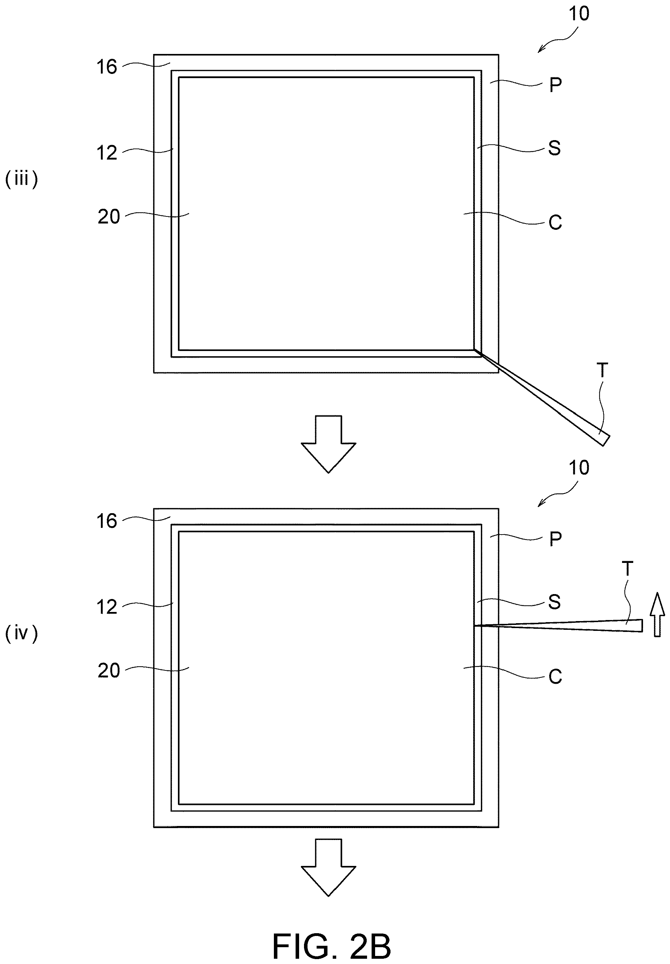

Optionally, the gap G is enlarged by moving the thin piece T along the cut S starting from the formed gap G (Figure 2B(iv)). Enlarging the gap G in this way enables the smoother release of the carrier 12.

The thin piece T is preferably moved over a part or the entire length of the cut S, and more preferably performed over the entire length of the cut S. For example, when the cut S is formed in the rectangular pattern (four-sided linear pattern) described above, the gap G can be formed on each side by moving the thin piece T along the rectangular pattern. In particular, when the laminated sheet 10 has a polygonal shape, it is preferable to form the gap G including the corner portion (folded portion) of the cut S from the viewpoint of being able to smoothly perform the release by stress concentration in the gap G in the subsequent release step. When the carrier is a single-crystal silicon carrier in this gap enlargement step, the development direction of the cut S is preferably noted.

The insertion angle of the thin piece T with respect to the main surface of the carrier 12 during the movement of the thin piece T is not particularly limited, but typically falls within the range of θ ± 10° (provided θ ± 10° > 0°), where θ is the insertion angle of the thin piece T, during the formation of the gap G. During the movement of the thin piece T, the gap G may be enlarged while the thin piece T is tilted toward the moving direction.

### (5) Release of Carrier (Optional Step)

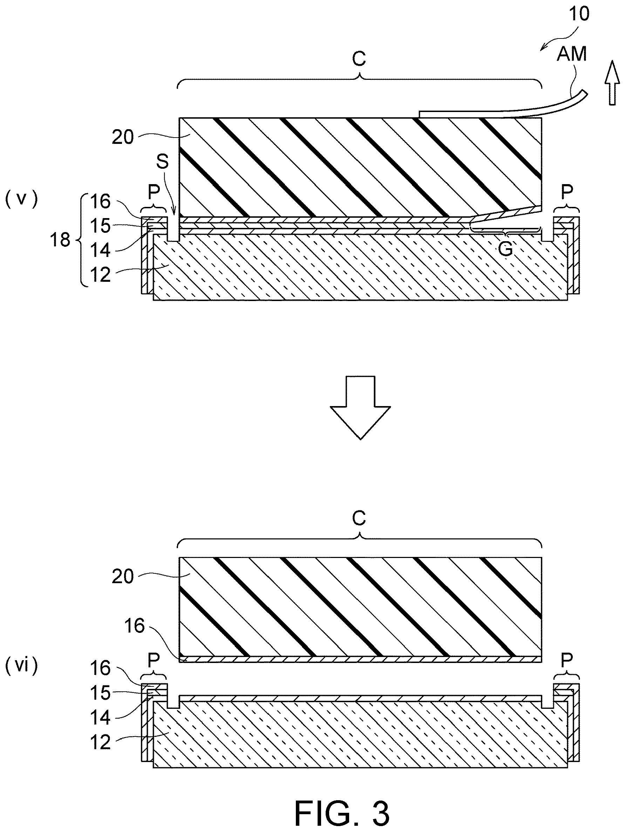

After the gap G is enlarged optionally, a force is applied to the laminated sheet 10 in a direction in which the carrier 12 and the metal layer 16 (on the central portion C side) are separated from each other (Figure 3(v)). This makes it possible to release the metal layer 16 (and, when present, the resin-containing layer 20) from the carrier 12 with the gap G as a trigger (Figure 3(vi)). That is, as described above, by forming and enlarging the gap G, a stress concentration portion to serve as the starting point at which the metal layer 16 and the carrier 12 release from each other can be formed in the release step, thus enabling easy release of the metal layer 16.

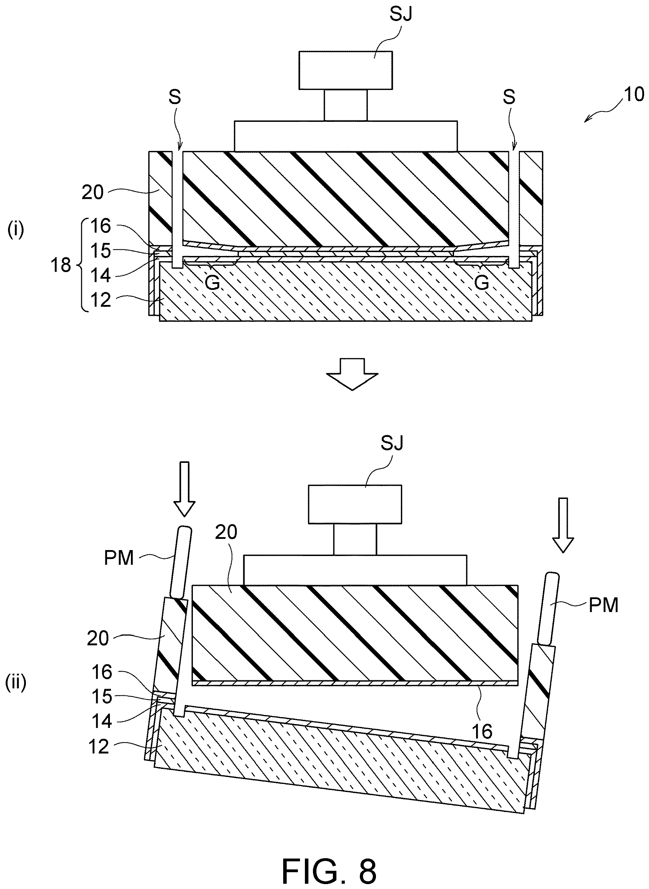

The metal layer 16 is preferably released while the outer edge portion of the carrier 12 or the laminated sheet 10 is gripped or supported, for example. Note that the "support" here includes a method of fixing at least a part of the carrier. For example, as shown in Figure 3(v), while the carrier 12 or the like is gripped or supported, an adhesive member AM is attached to the metal layer 16 or the resin-containing layer 20 (on the central portion C side), and the adhesive member AM is pulled in a direction away from the carrier 12 (in the direction of an arrow in the figure), thereby enabling the release of the metal layer 16 and the resin-containing layer 20. Alternatively, while the carrier 12 or the like is gripped or supported, the metal layer 16 or the like may be released using wind pressure or water pressure by jetting wind, water, or the like into the gap G at a predetermined pressure. In addition, as shown in Figures 8(i) and 8 (ii), while the central portion C side of the metal layer 16 or the resin-containing layer 20 is sucked by the suction jig SJ or the like, the peripheral portion P side of the metal layer 16 or the resin-containing layer 20 may be pressed in a direction opposite to the suction direction using a pressing member PM or the like to release the metal layer 16 or the like.

When the carrier is a single-crystal silicon carrier in this release step, the development direction of the release is preferably noted. That is, as shown in Figures 9B(iii) and 9B(iv), when the release is performed in a direction where a direction in which the external stress ST develops matches the cleavage orientation CL, there is a possibility of breakage in the silicon carrier, such as the occurrence of the crack CR along the cleavage orientation CL, starting from the point to which the external stress ST is applied due to the first release. In order to inhibit such breakage in the silicon carrier due to cleavage, when the carrier 12 is a single-crystal silicon carrier, as shown in Figures 10B(iii) and 10B(iv), the external stress ST is preferably applied in a direction that does not match either direction of the cleavage orientation CL, on the x-axis (horizontal direction in the figure) and the y-axis (vertical direction in the figure) on the silicon carrier, to release the carrier 12.

Therefore, according to the preferred aspect of the present invention, the carrier 12 is a single-crystal silicon carrier having a notch or the like on the periphery, and in the carrier release step, when the angle θ is defined right-handed (clockwise) starting from the half line that extends from the center of the single-crystal silicon carrier to the notch or the like, the release is performed so that the development direction of the external stress falls within the range of 1° <θ < 89°.

A more specific description will be provided. As shown in Figures 9A(i) and 10A(i), when the angle θ is defined right-handed (clockwise) starting from the half line L that extends from the center of the carrier 12 to the notch N or the midpoint of the orientation flat OF, values of θ at 0°, 90°, 180°, and 270° correspond to the cleavage orientation CL. Therefore, as shown in Figure 10B(iii), when θr represents the direction of the development of the external stress ST due to the release, the release is preferably performed while the development direction of the external stress ST is maintained so that θr falls within the range of 1° < θr < 89°, and more preferably within the range of 5° < θr < 85°. The release method that satisfies such a range of θr can inhibit breakage in the carrier 12 that is composed of a silicon wafer. Particularly preferred ranges of θr during this release are θr = within 45 ± 5°, within 135 ± 5°, within 225 ± 5°, and within 315 ± 5°, right-handed starting from the half line L. The wafer is least likely to cleave at these angles in the <100> direction of the crystal orientation of the silicon wafer, so that it is possible to remove the carrier while effectively inhibiting breakage in the wafer by developing the external stress at these angles. When the carrier is removed by the method in which the adhesive member AM is attached to the metal layer 16 or the resin-containing layer 20 and the adhesive member AM is pulled in a direction away from the carrier 12, as described above (see Figure 3(v)), the propagation direction of tensile stress caused by the adhesive member AM is preferably set within the range of θr described above. Alternatively, when the carrier is released by the method in which the peripheral portion P side of the metal layer 16 and the resin-containing layer 20 is pressed in a direction opposite to the suction direction using a pressing member PM or the like, as described above (see Figures 8(i) and 8 (ii)), the propagation direction of stress in the pushing direction caused by the pressing member PM or the like is preferably set within the range of θr described above.

When the laminated sheet 10 includes the resin-containing layer 20, the exposed metal layer 16 may be etched away after the release of the carrier 12. Thus, the wiring (buried wiring) formed on the surface of the metal layer 16 is exposed, which is more suitable for forming a further circuit thereon by a photolithography process. The etching of the metal layer 16 should be performed based on a known method and is not particularly limited.

### Carrier-Attached Metal Foil

As described above with reference to Figure 1A, the carrier-attached metal foil 18, which is optionally used in the method of the present invention, includes the carrier 12, optionally the intermediate layer 14, the release layer 15, and the metal layer 16 in order.

As described above, the material of the carrier 12 may be any one of glass, ceramic, silicon, a resin, and a metal. The carrier 12 is preferably composed of glass, polycrystalline silicon, single-crystal silicon, or ceramic. The form of the carrier 12 may be any one of a sheet, a film, and a plate. The carrier 12 may be a laminate of these sheets, films, plates, and the like. For example, the carrier 12 may be one that can function as a support having rigidity, such as a glass plate, a ceramic plate, a silicon wafer, or a metal plate, or may be in the form of having no rigidity, such as a metal foil or a resin film. Preferred examples of the metal constituting the carrier 12 include copper, titanium, nickel, stainless steel, and aluminum. Preferred examples of the ceramic include alumina, zirconia, silicon nitride, aluminum nitride, and various other fine ceramics. Preferred examples of the resin include polyethylene terephthalate (PET), polyethylene naphthalate (PEN), polyamides, polyimides, nylons, liquid crystal polymers, polyetheretherketone (PEEK (^{®})), polyamide-imides, polyethersulfone, polyphenylene sulfide, polytetrafluoroethylene (PTFE), and ethylene tetrafluoroethylene (ETFE). More preferably, from the viewpoint of preventing the warpage of a coreless support accompanying heating at the time of mounting a semiconductor device, a material having a coefficient of thermal expansion (CTE) of less than 25 ppm/K (typically 1.0 ppm/K or more and 23 ppm/K or less) is used. Examples of such a material include various resins (particularly low thermal expansion resins such as polyimides and liquid crystal polymers), glass, silicon, and ceramic as described above. From the viewpoint of handleability and ensuring flatness during chip mounting, the carrier 12 preferably has a Vickers hardness of 100 HV or more, and more preferably 150 HV or more and 2500 HV or less. As a material satisfying these characteristics, the carrier 12 is preferably composed of glass, silicon, or ceramic, more preferably glass or ceramic, and particularly preferably glass. Examples of the carrier 12 composed of glass include a glass plate. When glass is used as the carrier 12, the advantages are that it is lightweight, has a low coefficient of thermal expansion, has high insulating properties, and is rigid and has a flat surface to enable the surface of the metal layer 16 to be extremely smoothed. In addition, when the carrier 12 is glass, the advantages are that it has surface flatness (coplanarity) advantageous for fine circuit formation, that it has chemical resistance in desmear and various plating steps in a wiring manufacturing process, and that a chemical separation method can be adopted when the carrier 12 is released from the carrier-attached metal foil 18. Preferred examples of the glass constituting the carrier 12 include quartz glass, borosilicate glass, alkali-free glass, soda lime glass, aluminosilicate glass, and combinations thereof, more preferably alkali-free glass, soda lime glass, and combinations thereof, and particularly preferably alkali-free glass. The alkali-free glass is glass containing substantially no alkali metals that is mainly composed of silicon dioxide, aluminum oxide, boron oxide, and alkaline earth metal oxides such as calcium oxide and barium oxide as main components and further contains boric acid. This alkali-free glass has an advantage of having a low and stable coefficient of thermal expansion in the range of 3 ppm/K or more and 5 ppm/K or less in a wide temperature zone of 0°C to 350°C, thus enabling the warpage of the glass in a process involving heating to be minimized. The thickness of the carrier 12 is preferably 100 µm or more and 2000 µm or less, more preferably 300 µm or more and 1800 µm or less, and further preferably 400 µm or more and 1100 µm or less. When the carrier 12 has a thickness within such a range, it is possible to achieve the thinning of wiring and the reduction in warpage that occurs during electronic component mounting, while ensuring suitable strength that does not hinder handling.

The optionally provided intermediate layer 14 may have a one-layer configuration or a configuration of two or more layers. When the intermediate layer 14 is composed of two or more layers, the intermediate layer 14 includes a first intermediate layer provided directly on the carrier 12, and a second intermediate layer provided adjacent to the release layer 15. The first intermediate layer is preferably a layer composed of at least one metal selected from the group consisting of Ti, Cr, Al, and Ni from the viewpoint of ensuring adhesion to the carrier 12. The first intermediate layer may be a pure metal or an alloy. The thickness of the first intermediate layer is preferably 5 nm or more and 500 nm or less, more preferably 10 nm or more and 300 nm or less, further preferably 18 nm or more and 200 nm or less, and particularly preferably 20 nm or more and 100 nm or less. The second intermediate layer is preferably a layer composed of Cu, in terms of controlling the release strength between the second intermediate layer and the release layer 15 to the desired value. The thickness of the second intermediate layer is preferably 5 nm or more and 500 nm or less, more preferably 10 nm or more and 400 nm or less, further preferably 15 nm or more and 300 nm or less, and particularly preferably 20 nm or more and 200 nm or less. Another interposed layer may be present between the first intermediate layer and the second intermediate layer, and examples of the constituent material of the interposed layer include alloys of at least one metal selected from the group consisting of Ti, Cr, Mo, Mn, W, and Ni, and Cu. On the other hand, when the intermediate layer 14 has a one-layer configuration, the first intermediate layer described above may be adopted as it is as the intermediate layer, or the first intermediate layer and the second intermediate layer may be replaced by one intermediate alloy layer. This intermediate alloy layer is preferably composed of a copper alloy in which the content of at least one metal selected from the group consisting of Ti, Cr, Mo, Mn, W, Al, and Ni is 1.0 at% or more, and the Cu content is 30 at% or more. The thickness of the intermediate alloy layer is preferably 5 nm or more and 500 nm or less, more preferably 10 nm or more and 400 nm or less, further preferably 15 nm or more and 300 nm or less, and particularly preferably 20 nm or more and 200 nm or less. Note that the thickness of each layer described above is a value measured by analyzing a layer cross section by a transmission electron microscope-energy dispersive X-ray spectrometer (TEM-EDX). The metal constituting the intermediate layer 14 may contain unavoidable impurities resulting from the raw material component, the film formation step, and the like. In the case of exposure to the air after the film formation of the intermediate layer 14, the presence of oxygen mixed due to the exposure is allowed. The intermediate layer 14 may be manufactured by any method, but is particularly preferably a layer formed by a magnetron sputtering method using a metal target because the layer allows for the uniformity of film thickness distribution.

The release layer 15 is a layer that enables or facilitates the release of the carrier 12 and, when present, the intermediate layer 14. The release layer 15 may be a layer that can be released using a laser release method (laser lift-off, LLO) in addition to a layer that can be released using a method of physically applying a force. When the release layer 15 is composed of a material that can be released by laser lift-off, the release layer 15 may be composed of a resin with its adhesive strength at the interface reduced by laser beam irradiation after curing, or may be a layer of silicon, silicon carbide, metal oxide, or the like that is modified by laser beam irradiation. The release layer 15 may be either an organic release layer or an inorganic release layer. Examples of the organic component used for the organic release layer include nitrogen-containing organic compounds, sulfur-containing organic compounds, and carboxylic acids. Examples of the nitrogen-containing organic compounds include triazole compounds and imidazole compounds. On the other hand, examples of the inorganic component used for the inorganic release layer include metal oxides or metal oxynitrides including at least one or more of Cu, Ti, Al, Nb, Zr, Cr, W, Ta, Co, Ag, Ni, In, Sn, Zn, Ga, and Mo, or carbon. Among these, the release layer 15 is preferably a layer mainly containing carbon, in terms of ease of release, layer formation properties, and the like, more preferably a layer mainly composed of carbon or a hydrocarbon, and further preferably a layer composed of amorphous carbon, a hard carbon film. In this case, the release layer 15 (that is, a carbon-containing layer) preferably has a carbon concentration of 60 atomic% or more, more preferably 70 atomic% or more, further preferably 80 atomic% or more, and particularly preferably 85 atomic% or more as measured by x-ray photoelectron spectroscopy (XPS). The upper limit value of the carbon concentration is not particularly limited and may be 100 atomic% but is practically 98 atomic% or less. The release layer 15 can contain unavoidable impurities (for example, oxygen, carbon, and hydrogen, which are derived from the surrounding environment such as the atmosphere). In the release layer 15, atoms of metals of types other than the metal contained as the release layer 15 can be mixed due to the film formation method of the metal layer 16 or the like to be laminated later. When a carbon-containing layer is used as the release layer 15, the interdiffusivity and reactivity with the carrier are low, and even if the layer is subjected to pressing at a temperature exceeding 300°C, mutual diffusion of metal elements due to high-temperature heating between the metal layer and the bonding interface can be prevented to maintain a state where the release and removal of the carrier is easy. The release layer 15 is preferably a layer formed by a vapor phase method such as sputtering, in terms of inhibiting excessive impurities in the release layer 15, achieving the continuous productivity of other layers, and other respects. The thickness when a carbon-containing layer is used as the release layer 15 is preferably 1 nm or more and 20 nm or less, and more preferably 1 nm or more and 10 nm or less. This thickness is a value measured by analyzing a layer cross section by a transmission electron microscope-energy dispersive X-ray spectrometer (TEM-EDX).

The release layer 15 may be a layer including both a metal oxide layer and a carbon-containing layer or including both a metal oxide and carbon. Particularly, when the carrier-attached metal foil 18 includes the intermediate layer 14, the carbon-containing layer can contribute to the stable release of the carrier 12, and the metal oxide layer can more effectively inhibit the diffusion of the metal elements derived from the intermediate layer 14 and the metal layer 16, accompanying heating. As a result, even after the heating at a temperature as high as, for example, 350°C or more, stable releasability can be maintained. The metal oxide layer is preferably a layer including an oxide of metals composed of Cu, Ti, Al, Nb, Zr, Cr, W, Ta, Co, Ag, Ni, In, Sn, Zn, Ga, Mo, and combinations thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the release layer 15 is not particularly limited. The release layer 15 may be present in a state of a mixed phase in which the boundary between the metal oxide layer and the carbon-containing layer is not clearly identified (that is, a layer containing both metal oxide and carbon).

Similarly, from the viewpoint of maintaining stable releasability even after heat treatment at high temperatures, the release layer 15 may be a metal-containing layer in which the surface on the side adjacent to the metal layer 16 is a fluorination-treated surface and/or a nitriding-treated surface. In the metal-containing layer, a region in which the sum of the content of fluorine and the content of nitrogen is 1.0 atomic% or more (hereinafter referred to as a "(F + N) region") is preferably present over a thickness of 10 nm or more, and the (F + N) region is preferably present on the metal layer 16 side of the metal-containing layer. The thickness (in terms of SiO₂) of the (F + N) region is a value specified by performing the depth profile elemental analysis of the carrier-attached metal foil 18 using XPS. The fluorination-treated surface or the nitriding-treated surface can be preferably formed by reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic% or more and 100 atomic% or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the release layer 15 may be a metal oxynitride-containing layer instead of a carbon layer or the like. The surface of the metal oxynitride-containing layer opposite to the carrier 12 (that is, on the metal layer 16 side) preferably includes at least one metal oxynitride selected from the group consisting of TaON, NiON, TiON, NiWON, and MoON. In terms of ensuring the adhesion between the carrier 12 and the metal layer 16, the surface of the metal oxynitride-containing layer on the carrier 12 side preferably includes at least one selected from the group consisting of Cu, Ti, Ta, Cr, Ni, Al, Mo, Zn, W, TiN, and TaN. Thus, the number of foreign matter particles on the surface of the metal layer 16 is suppressed to improve circuit formation properties, and even after heating at high temperatures for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

The metal layer 16 is a layer composed of metal. The metal layer 16 may have a one-layer configuration or a configuration of two or more layers. When the metal layer 16 is composed of two or more layers, the metal layer 16 can have a configuration in which metal layers from a first metal layer to an m-th metal layer (m is an integer of 2 or more) are laminated in order on the surface side of the release layer 15 opposite to the carrier 12. The thickness of the entire metal layer 16 is preferably 1 nm or more and 2000 nm or less, preferably 100 nm or more and 1500 nm or less, more preferably 200 nm or more and 1000 nm or less, further preferably 300 nm or more and 800 nm or less, and particularly preferably 350 nm or more and 500 nm or less. The thickness of the metal layer 16 is a value measured by analyzing a layer cross section by a transmission electron microscope-energy dispersive X-ray spectrometer (TEM-EDX). An example in which the metal layer 16 is composed of two layers, a first metal layer and a second metal layer, will be described below.

The first metal layer preferably provides the desired functions such as an etching stopper function and an antireflection function to the carrier-attached metal foil 18. Preferred examples of the metal constituting the first metal layer include Ti, Al, Nb, Zr, Cr, W, Ta, Co, Ag, Ni, Mo, and combinations thereof, more preferably Ti, Zr, Al, Cr, W, Ni, Mo, and combinations thereof, further preferably Ti, Al, Cr, Ni, Mo, and combinations thereof, and particularly preferably Ti, Mo, and combinations thereof. These elements have the property of not dissolving in flash etchants (for example, copper flash etchants) and, as a result, can exhibit excellent chemical resistance to flash etchants. Therefore, the first metal layer is a layer less likely to be etched with a flash etchant than the second metal layer to be described later, and can thus function as an etching stopper layer. In addition, the metal constituting the first metal layer described above also has the function of preventing the reflection of light, and hence the first metal layer can also function as an antireflection layer for improving visibility in image inspection (for example, automatic image inspection (AOI)). The first metal layer may be a pure metal or an alloy. The metal constituting the first metal layer may contain unavoidable impurities resulting from the raw material component, the film formation step, and the like. The upper limit of the content of the metal is not particularly limited and may be 100 atomic%. The first metal layer is preferably a layer formed by a physical vapor deposition (PVD) method, and more preferably a layer formed by sputtering. The thickness of the first metal layer is preferably 1 nm or more and 500 nm or less, more preferably 10 nm or more and 400 nm or less, further preferably 30 nm or more and 300 nm or less, and particularly preferably 50 nm or more and 200 nm or less.

Preferred examples of the metal constituting the second metal layer include the transition elements of groups 4, 5, 6, 9, 10, and 11, Al, and combinations thereof (for example, alloys and intermetallic compounds), more preferably the transition elements of groups 4 and 11, Al, Nb, Co, Ni, Mo, and combinations thereof, further preferably the transition elements of group 11, Ti, Al, Mo, and combinations thereof, particularly preferably Cu, Ti, Mo, and combinations thereof, and most preferably Cu. The second metal layer may be manufactured by any method and may be a metal foil formed by, for example, wet film formation methods such as an electroless metal plating method and an electrolytic metal plating method, physical vapor deposition (PVD) methods such as sputtering and vacuum deposition, chemical vapor film formation, or combinations thereof. A particularly preferred second metal layer is a metal layer formed by physical vapor deposition (PVD) methods such as a sputtering method and vacuum deposition, most preferably a metal layer manufactured by a sputtering method, from the viewpoint of being easily adapted to a fine pitch due to superthinning. The second metal layer is preferably a metal layer without roughening treatment, but may be one in which secondary roughening is performed by preliminary roughening, soft etching treatment, rinse treatment, or oxidation-reduction treatment, as long as wiring pattern formation is not hindered. From the viewpoint of being adapted to a fine pitch, the thickness of the second metal layer is preferably 10 nm or more and 1000 nm or less, more preferably 20 nm or more and 900 nm or less, further preferably 30 nm or more and 700 nm or less, further more preferably 50 nm or more and 600 nm or less, particularly preferably 70 nm or more and 500 nm or less, and most preferably 100 nm or more and 400 nm or less. The metal layer having a thickness within such a range is preferably manufactured by a sputtering method from the viewpoint of the in-plane uniformity of film formation thickness, and productivity in a sheet form or a roll form.

When the metal layer 16 has a one-layer configuration, the second metal layer described above is preferably adopted as it is as the metal layer 16. On the other hand, when the metal layer 16 has an n-layer (n is an integer of 3 or more) configuration, the metal layers from the first to the (n-1)th in the metal layer 16 preferably have the configuration of the first metal layer described above, and the outermost layer, that is, the n-th metal layer, in the metal layer 16 preferably has the configuration of the second metal layer described above.

The end face of the carrier 12 is preferably covered by the extension of the metal layer 16, optionally the intermediate layer 14, and optionally the release layer 15 (that is, at least the metal layer 16, for example, the metal layer 16 and the intermediate layer 14) to the end face. That is, not only the surface but also the end face of the carrier 12 is preferably covered with at least the metal layer 16. By covering the end face as well, it is possible to prevent the infiltration of chemical liquids into the carrier 12 in the wiring substrate manufacturing process, and also to strongly prevent chipping due to release at the side end when the carrier-attached metal foil 18 or the laminated sheet 10 is handled, that is, chipping of the film on the release layer 15 (that is, the metal layer 16). The covered region on the end face of the carrier 12 is preferably a region 0.1 mm or more and more preferably 0.2 mm or more from the surface of the carrier 12 toward the thickness direction (that is, the direction perpendicular to the carrier surface), and is further preferably throughout the end face of the carrier 12.

### EXAMPLES

The present invention will be further described by the following examples.

### Example 1

### (1) Preparation of Laminated Sheet

A glass substrate (material: soda-lime glass) with a size of 320 mm x 320 mm and a thickness of 1.1 mm was provided as the carrier 12. On the carrier 12, a titanium layer (thickness 50 nm) and a copper layer (thickness 200 nm) as the intermediate layer 14, an amorphous carbon layer (thickness 6 nm) as the release layer 15, and a titanium layer (thickness 100 nm) and a copper layer (thickness 300 nm) as the metal layer 16 were deposited by sputtering in this order to obtain the carrier-attached metal foil 18. On the metal layer 16 of the carrier-attached metal foil 18, a resin layer (material: epoxy resin) with a size of 300 mm x 300 mm and a thickness of 300 µm was formed to obtain the resin-containing layer 20. Thus, a laminated sheet 10 provided with the carrier 12, the intermediate layer 14, the release layer 15, the metal layer 16, and the resin-containing layer 20 in this order was prepared (see Figures 1A(i) and 1B(i)).

### (2) Formation of Cut

A cut S (width 0.5 mm) was formed by inserting the blade of a cutter CT (material: tungsten) perpendicular to the main surface of the carrier 12 from the surface of the metal layer 16 of the laminated sheet 10. The cut S was formed in a rectangular pattern (four-sided linear pattern) to surround the resin-containing layer 20 when the laminated sheet 10 was seen in a planar view (see Figure 1B(ii)). The cut S was made to be deep enough to penetrate the metal layer 16, the release layer 15, and the intermediate layer 14, but not to penetrate the carrier 12 when the laminated sheet 10 was seen in a cross-sectional view (see Figure 1A(ii)). Thus, the metal layer 16, the release layer 15, and the intermediate layer 14 were divided into a central portion C and a peripheral portion P with the cut S as the boundary.

### (3) Formation of Gap

A rotary blade RC (diameter 45 mm, blade thickness 0.3 mm, blade angle 21°, material: tungsten) was inserted from the corner of the cut S toward the central portion side of the metal layer 16, the release layer 15, and the intermediate layer 14 (see Figures 2A(iii) and 2B(iii)). The insertion angle θ of the rotary blade RC with respect to the main surface of the carrier 12 when the laminated sheet 10 was seen in a cross-sectional view was 45°. The insertion width of the rotary blade RC into the laminated sheet 10 was 2 mm. Thus, a gap G was formed between the metal layer 16 and the carrier 12.

### (4) Enlargement of Gap

Starting from the gap G formed, the rotary blade RC was moved along the cut S (see Figures 2A(iv) and 2B(iv)). By moving the rotary blade RC along the rectangular pattern of the cut S in this way, the gap G was enlarged on each side.

### (5) Release of Carrier

With the peripheral portion P of the laminated sheet 10 supported, a commercially available adhesive tape AM was attached to the corner of the resin-containing layer 20 and pulled up in a direction away from the carrier 12, whereby the resin-containing layer 20 and the metal layer 16 were released from the carrier 12 (see Figures 3(v) and(vi)).

## Claims

1. A method for manufacturing a wiring substrate, comprising the steps of:
providing a laminated sheet that includes a release layer and a metal layer in order on a carrier;
forming a cut in the laminated sheet from a surface of the laminated sheet opposite to the carrier so that the cut passes through an inside of an outer edge portion of the laminated sheet when the laminated sheet is seen in a planar view and so that the cut penetrates the metal layer and the release layer when the laminated sheet is seen in a cross-sectional view, and dividing the metal layer and the release layer into a central portion and a peripheral portion with the cut as a boundary; and
inserting a thin piece from the cut toward the central portion side of the metal layer or the release layer to form a gap between the metal layer and the carrier in which an insertion angle of the thin piece with respect to a main surface of the carrier is greater than 0° when the laminated sheet is seen in the cross-sectional view.

2. A method for manufacturing a wiring substrate, comprising the steps of:
providing a laminated sheet that includes a release layer and a metal layer in order on a carrier;
forming a cut in the laminated sheet from a surface of the laminated sheet opposite to the carrier so that the cut passes through an inside of an outer edge portion of the laminated sheet when the laminated sheet is seen in a planar view and so that the cut penetrates the metal layer and the release layer when the laminated sheet is seen in a cross-sectional view, and dividing the metal layer and the release layer into a central portion and a peripheral portion with the cut as a boundary; and
inserting a thin piece from the cut toward the central portion side of the metal layer or the release layer to form a gap between the metal layer and the carrier in which an insertion angle of the thin piece with respect to a main surface of the carrier is greater than 0° when the laminated sheet is seen in the cross-sectional view,
wherein the carrier is a single-crystal silicon carrier having a notch or an orientation flat on a periphery, and in the step of forming the cut, the cut is made so that when an angle θ is defined right-handed, or clockwise, starting from a half line that extends from a center of the single-crystal silicon carrier to a midpoint of the notch or the orientation flat, a direction of development of external stress falls within a range of 1° <θ < 89°.

3. The method for manufacturing the wiring substrate according to claim 1 or 2, further comprising the step of moving the thin piece along the cut, starting from the gap formed, to enlarge the gap.

4. The method for manufacturing the wiring substrate according to claim 3, further comprising the step of applying, after the enlargement of the gap, a force to the laminated sheet in a direction that causes the carrier and the metal layer to separate to release the metal layer from the carrier with the gap as a trigger.

5. The method for manufacturing the wiring substrate according to claim 1 or 2, wherein the cut is formed so that at least a part of the carrier is unpenetrated when the laminated sheet is seen in a cross-sectional view.

6. The method for manufacturing the wiring substrate according to claim 1 or 2, wherein the cut has a width of 0.01 mm or more and 20 mm or less.

7. The method for manufacturing the wiring substrate according to claim 1 or 2, wherein the thin piece is a cutting blade, and the cutting blade is one of a flat blade, a triangular blade, a square blade, a circular blade, and a rotary blade.

8. The method for manufacturing the wiring substrate according to claim 1 or 2, wherein the cut is formed in a linear pattern so that the peripheral portion surrounds the central portion when the laminated sheet is seen in a planar view.

9. The method for manufacturing the wiring substrate according to claim 3, wherein the thin piece is moved over a part or an entire length of the cut.

10. The method for manufacturing the wiring substrate according to claim 4, wherein the metal layer is released in a state where an outer edge portion of the carrier or the laminated sheet is gripped or supported.

11. The method for manufacturing the wiring substrate according to claim 1 or 2, wherein the insertion angle is greater than 0.1° and less than or equal to 60°.

12. The method for manufacturing the wiring substrate according to claim 1 or 2, wherein an insertion width of the thin piece into the laminated sheet in a formation of the gap is 0.1 mm or more.

13. The method for manufacturing the wiring substrate according to claim 1 or 2, wherein the thin piece is composed of at least one selected from the group consisting of a ferrous material, a nonferrous metal, ceramic, and diamond.

14. The method for manufacturing the wiring substrate according to claim 1 or 2, wherein the laminated sheet further includes a resin-containing layer on a surface of the metal layer opposite to the release layer.

15. The method for manufacturing the wiring substrate according to claim 14, wherein the resin-containing layer includes at least one selected from the group consisting of a wiring layer, a semiconductor device, and a resin layer.

16. The method for manufacturing the wiring substrate according to claim 14, wherein the resin-containing layer has a thickness of 1000 µm or less.

17. The method for manufacturing the wiring substrate according to claim 14, wherein the insertion of the thin piece in a formation of the gap is performed into the resin-containing layer.
